# FASCICULE DE BREVET EUROPEEN

(11) **EP 1 198 611 B1**
(45) Date de publication et mention de la délivrance du brevet: **02.07.2003**
(21) Numéro de dépôt: 00918933.3
(22) Date de dépôt: 11.04.2000
(51) Int. Cl.: C23C 16/04, C23C 16/50, H01J 37/32

(54) **DISPOSITIF POUR LE TRAITEMENT D'UN RECIPIENT PAR PLASMA MICRO-ONDES**
VORRICHTUNG ZUM BEHANDELN EINES BEHÄLTERS MIT EINEM MIKROWELLEN-PLASMA
DEVICE FOR TREATING A CONTAINER WITH MICROWAVE PLASMA

(30) Priorité: 29.04.1999 FR 9906178
(43) Date de publication de la demande: 24.04.2002
(73) Titulaire: Sidel Actis Services, 76053 Le Havre Cedex (FR)
(72) Inventeur: CHOLLET, Patrick, F-76053 Le Havre Cedex (FR)
(74) Mandataire: Siloret, Patrick
(86) Numéro de dépôt international: FR0000916
(87) Numéro de publication internationale: WO00066804

(56) Documents cités:
- EP-A- 0 346 168
- EP-A- 0 881 197
- WO-A-99/17334

## Description

L'invention se rapporte au domaine des procédés de traitement de surfaces sur un récipient, par exemple en matériau thermoplastique.

L'invention trouvera par exemple application dans le domaine du dépôt de couches minces à effet barrière sur des bouteilles ou des pots en matériaux thermoplastiques tels que le polyéthylène téréphtalate.

En effet, on cherche actuellement à améliorer les propriétés barrières de ces récipients, notamment en vue, de diminuer leur perméabilité aux gaz ou d'augmenter leur opacité à certains rayonnements, notamment les ultraviolets, ceci afin d'augmenter la durée de conservation des produits emballés dans ces récipients.

Dans ce but, divers procédés voir, par exemple, WO 99/17334 ont été proposés qui visent soit à modifier directement le matériau du récipient, au moins en surface, soit à recouvrir les récipients d'une couche de matériau organique ou inorganique permettant d'améliorer les propriétés du récipient. Pour réaliser de tels traitements, une voie particulièrement intéressante consiste à effectuer un traitement par plasma à basse pression. Dans un tel procédé, on crée à l'intérieur de l'enceinte un vide en même temps que l'on y injecte un fluide réactionnel sous une pression absolue de préférence inférieure à 1 mbar. Le fluide réactionnel varie en fonction de la nature du matériau que l'on souhaite déposer. Il comporte un précurseur du matériau à déposer, généralement sous la forme d'un gaz ou d'un mélange de gaz. Il peut aussi comporter un gaz porteur.

Ce fluide réactionnel est soumis à un rayonnement électromagnétique de type micro-ondes propre à exciter le précurseur pour former un plasma qui crée des molécules actives. Dans le cas d'un traitement de dépôt, ces molécules peuvent se déposer sur la surface du récipient par le biais d'une liaison physico-chimique particulièrement forte qui garantit la stabilité du matériau déposé. Toutefois, dans certains cas, le traitement peut consister en une simple modification de la surface du matériau constitutif du récipient. Il n'y alors pas de dépôt d'une nouvelle couche de matière mais modification du matériau du récipient par interaction avec les molécules ou espèces actives du plasma.

L'utilisation de rayonnements électromagnétiques de type micro-ondes permet notamment d'obtenir des dépôts ayant une structure particulière impossible à obtenir avec d'autres rayonnements tels que les rayonnements de type radiofréquences qui sont largement utilisés.

Une des difficultés que l'on rencontre dans la mise en oeuvre de ces procédés réside dans le fait d'obtenir une uniformité du traitement sur toute la surface à revêtir. Dans le cas d'un traitement de dépôt, ces problèmes d'homogénéité peuvent avoir des répercussions en termes d'épaisseur de la couche déposée et en termes de composition de cette couche. Bien entendu, cette mauvaise homogénéité de la couche déposée n'est pas satisfaisante.

Or, l'obtention d'un traitement homogène passe notamment par l'utilisation d'un plasma présentant la plus grande uniformité possible.

L'invention a donc pour but de proposer un dispositif permettant d'obtenir une propagation optimale des micro-ondes apte à garantir une bonne homogénéité du plasma. Pour les traitements de dépôt, ce dispositif doit de plus permettre que cette homogénéité soit obtenue tout en utilisant des temps de traitement compatibles avec une utilisation industrielle, c'est-à-dire avec des vitesses de dépôt relativement importantes.

Dans ce but, l'invention propose un dispositif pour le traitement de surface d'un récipient, du type dans lequel le traitement est réalisé à l'aide d'un plasma à basse pression par excitation d'un fluide réactif grâce à des ondes électromagnétiques de type micro-ondes, et du type dans lequel le récipient est placé dans une enceinte en matériau conducteur à l'intérieur de laquelle les micro-ondes sont introduites par l'intermédiaire d'un dispositif de couplage, caractérisé en ce que l'enceinte est cylindrique de révolution autour d'un axe principal du récipient, en ce que le dispositif de couplage comporte un tunnel guide d'onde qui s'étend selon une direction sensiblement perpendiculaire à l'axe de l'enceinte et qui débouche dans une paroi latérale de celle-ci sous la forme d'une fenêtre qui, en projection sur un plan tangent à l'enceinte, présente une forme rectangulaire dont la plus petite dimension correspond à sa dimension selon la direction de l'axe de l'enceinte, et en ce que le diamètre interne de l'enceinte est tel que les micro-ondes se propagent dans l'enceinte principalement selon un mode dans lequel le champ électrique résultant de la propagation des micro-ondes présente une symétrie axiale de révolution.

Selon d'autres caractéristiques de l'invention :
- lorsque les micro-ondes sont introduites dans l'enceinte en l'absence de récipient, la variation de l'intensité du champ électrique présente deux maxima sur un rayon de l'enceinte ;
- les micro-ondes ont une fréquence de 2,45 GHz, et le diamètre interne de l'enceinte est compris entre 213 et 217 mm ;
- lorsque les micro-ondes sont introduites dans l'enceinte en l'absence de récipient, la variation de l'intensité du champ électrique présente trois maxima sur un rayon de l'enceinte ;
- les micro-ondes ont une fréquence de 2,45 GHz, et le diamètre interne de l'enceinte est compris entre 334 et 340 mm ;
- lorsque les micro-ondes sont introduites dans l'enceinte en l'absence de récipient, la variation de l'intensité du champ électrique présente quatre maxima sur un rayon de l'enceinte ;
- les micro-ondes ont une fréquence de 2,45 GHz, et le diamètre interne de l'enceinte est compris entre 455 et 465 mm ;
- le tunnel guide d'onde est de section rectangulaire ;
- les micro-ondes ont une fréquence de 2,45 GHz, en ce que la section du tunnel guide d'onde présente des dimensions d'environ 43 mm selon la direction de l'axe de l'enceinte et d'environ 86 mm selon la direction perpendiculaire ;
- le fluide réactif est introduit à l'intérieur du récipient de manière que le traitement s'effectue sur la face interne du récipient ;
- le fluide réactif est introduit dans l'enceinte, à l'extérieur du récipient, de manière que le traitement s'effectue sur la face externe du récipient ;
- à l'intérieur de l'enceinte, une cavité est délimitée par une paroi réalisée en un matériau qui est sensiblement transparent aux micro-ondes, et le récipient est reçu à l'intérieure de la cavité ; et
- le traitement comprend une étape de dépôt d'un matériau par plasma basse pression.

D'autres caractéristiques et avantages de l'invention apparaîtront à la lecture de la description détaillée qui suit ainsi que dans le dessin annexé dans lequel la figure unique illustre de manière schématique un dispositif conforme aux enseignements de l'invention.

Le dispositif illustré schématiquement sur la figure unique est un poste de traitement 10 conforme aux enseignements de l'invention. Il est plus particulièrement destiné à assurer la mise en oeuvre d'un procédé de dépôt par plasma à basse pression d'un revêtement sur la face interne d'un récipient en matériau thermoplastique.

A titre d'exemple, le récipient peut être une bouteille en polyéthylène téréphtalate (PET) et le revêtement à former peut être constitué d'un matériau à base de carbone. Toutefois, l'invention pourra avantageusement être mise en oeuvre pour d'autres récipients et pour d'autres types de revêtements, par exemple pour des revêtements à base d'oxydes de silicium ou d'oxydes aluminium. Tous ces revêtements sont en effet particulièrement intéressants car ils permettent de diminuer de manière importante la perméabilité d'une bouteille en PET vis-à-vis de gaz tels que l'oxygène et le dioxyde de carbone.

Le poste de traitement 10 est prévu pour traiter une bouteille à la fois. Toutefois, ce poste sera de préférence intégré à une machine rotative comportant une série de postes identiques, ceci afin de pouvoir traiter un grand nombre de bouteilles dans un temps donné.

Le poste 10 comporte donc une enceinte extérieure 12 en matériau conducteur, par exemple métallique. L'enceinte 12 est cylindrique d'axe A1 et, selon l'invention, elle est dimensionnée pour favoriser un mode particulier de couplage d'un champ électromagnétique de type micro-ondes.

En effet, le poste 10 comporte un générateur 14 qui est agencé à l'extérieur de l'enceinte 12 et qui est susceptible de délivrer un champ électromagnétique dans le domaine des micro-ondes. La fréquence du champ de micro-ondes délivré par le générateur 14 est par exemple de 2,45 GHz.

Le générateur 14 est monté dans un coffret 13 à l'extérieur de l'enceinte 12, et le rayonnement électromagnétique qu'il délivre est amené jusqu'à l'enceinte 12 par un guide d'ondes 15 en forme de tunnel qui s'étend selon un rayon de l'enceinte cylindrique et qui débouche au travers d'une fenêtre aménagée dans l'enceinte, sensiblement à mi-hauteur de celle-ci.

Comme cela sera divulgué en détails plus bas, la forme et les dimensions du guide d'ondes 15 sont elles aussi adaptées pour permettre un couplage favorable du champ de micro-ondes dans l'enceinte 12.

A l'intérieur de l'enceinte 12, on a disposé un tube 16 qui est coaxial à l'enceinte, qui est sensiblement transparent pour les micro-ondes, et qui délimite, à l'intérieur de l'enceinte 12, une cavité cylindrique 18 coaxiale à l'enceinte 12. Le tube 16 est par exemple réalisé en quartz. La cavité 18 est fermée à l'une de ses extrémités axiales, en l'occurrence l'extrémité inférieure, par une paroi transversale inférieure 26 de l'enceinte 12. Au contraire, l'extrémité supérieure de la cavité 18 est ouverte pour permettre l'introduction d'une bouteille à l'intérieur de la cavité dans laquelle elle va subir un traitement. La bouteille est disposée de manière sensiblement coaxiale à l'enceinte 12 et à la cavité 18.

Un couvercle 20 est destiné à refermer de manière étanche l'extrémité supérieure de la cavité 18 de telle sorte que l'on puisse y faire le vide. Pour permettre l'introduction du récipient 24 à l'intérieur de la cavité 18, le couvercle 20 est mobile axialement.

Sur le couvercle 20, il est prévu des moyens 22 pour maintenir le récipient 24 par le col, et des moyens pour créer différents niveaux de vide dans la cavité 18. Ainsi, dans le cas du traitement de la surface interne du récipient, on crée dans le récipient 24 un vide correspondant à une pression absolue d'environ 0,1 mbar, et, à l'extérieur de la bouteille, on crée un vide correspondant à une pression absolue d'environ 50 mbar. Le vide créé autour du récipient 24 évite que celui-ci ne soit soumis à un trop grand différentiel de pression qui conduirait à une déformation du récipient. Toutefois, ce vide n'est pas suffisamment poussé pour permettre la formation d'un plasma, ceci afin que l'énergie apportée par les micro-ondes ne soit pas dispersée à l'extérieur de la bouteille où on ne souhaite pas réaliser de dépôt. Un autre mode de fonctionnement est de créer, autour du récipient 24, un vide suffisamment bas, par exemple inférieur à 0,01 mbar, pour que le plasma ne puisse s'y amorcer. Ce mode de fonctionnement est techniquement moins intéressant car il faut plus de temps pour atteindre ce bas niveau de pression.

Bien entendu, le couvercle 20 comporte aussi des moyens pour injecter dans l'enceinte, en l'occurrence à l'intérieur du récipient 24, un fluide réactionnel qui contient au moins un précurseur pour le matériau que l'on souhaite déposer sur la paroi interne du récipient. On notera que le traitement du récipient 24 pourra aussi comporter la mise en oeuvre de procédés complémentaires au procédé de dépôt. On peut ainsi envisager d'effectuer un premier procédé de préparation de la surface du récipient avant d'effectuer le dépôt, ou d'effectuer un procédé ultérieur au dépôt.

Le dispositif comporte aussi des plateaux annulaires 28, 30 d'axe A1 qui sont disposés dans l'enceinte 12, autour du tube de quartz 16. Les deux plateaux 28, 30 sont décalés axialement l'un par rapport à l'autre de manière à être agencés axialement de part et d'autre de la fenêtre par laquelle le guide d'onde 15 débouche dans l'enceinte 12. Toutefois, leurs positions axiales respectives peuvent varier en fonction de la forme du récipient 24 à traiter. En effet, les plateaux 28, 30, qui sont réalisés en matériau conducteur de l'électricité, sont destinés à former des courts-circuits pour le champ électromagnétique introduit dans l'enceinte 12, ceci de manière à confiner axialement le champ pour avoir un maximum de l'intensité au niveau de la zone effective de traitement. Les plateaux 28, 30 sont donc portés par des tiges 32, 34 coulissantes axialement qui permettent un réglage rapide et aisé de la position axiale des plateaux.

Selon l'invention, le dispositif proposé doit permettre l'obtention, à l'intérieur de l'enceinte, d'un plasma présentant la plus grande homogénéité possible. Pour ce faire, il faut que l'intensité du champ électromagnétique soit répartie de la manière la plus uniforme possible, et notamment que l'intensité du champ en un point de l'enceinte soit sensiblement indépendante de la position axiale du point considéré, mais aussi sensiblement indépendante de la position angulaire de ce point autour de l'axe A1.

Pour ce faire, il est apparu que les meilleurs résultats ont été obtenus avec le poste de traitement tel que défini ci-dessous.

Le guide d'onde 15, dont on a vu qu'il s'étend selon un rayon par rapport à l'axe A1, est délimité radialement vers l'extérieur par une paroi de fond 36 agencée sensiblement à 185 mm de l'axe A1. Le guide d'onde 15 présente une section rectangulaire constante dont la hauteur selon la direction de l'axe A1 est d'environ 43 mm et dont la largeur est d'environ 86 mm.

Le générateur 14 est disposé de telle sorte que son antenne 38, qui pénètre dans le guide d'onde 15 par une ouverture aménagée dans une paroi inférieure du guide d'onde, soit située radialement par rapport à la paroi de fond 36 à la distance prédéterminée préconisée par le constructeur du générateur.

Toutefois, pour obtenir une répartition optimum de l'intensité du champ électromagnétique, il est apparu que le paramètre déterminant était le diamètre interne de l'enceinte 12.

En effet, dans le cadre de l'utilisation d'un générateur de micro-ondes à 2,45 GHz, des résultats particulièrement probants ont été obtenus pour les dans les trois cas suivants :
- le diamètre interne de l'enceinte est compris entre 213 et 217 mm, auquel cas, en l'absence de récipient et de vide dans la cavité, la variation de l'intensité du champ électrique présente deux maxima sur un rayon de l'enceinte ;
- le diamètre interne de l'enceinte est compris entre 334 et 340 mm, auquel cas, en l'absence de récipient et de vide dans la cavité, la variation de l'intensité du champ électrique présente trois maxima sur un rayon de l'enceinte ;
- le diamètre interne de l'enceinte est compris entre 455 et 465 mm, auquel cas, en l'absence de récipient et de vide dans la cavité, la variation de l'intensité du champ électrique présente quatre maxima sur un rayon de l'enceinte.

Ces résultats sont susceptibles d'être mis en évidence en disposant, à l'intérieur de l'enceinte, des feuilles de papier thermosensible selon diverses orientations (radiales, circonférentielles et transversales) pour obtenir une image du champ électromagnétique régnant dans l'enceinte. Dans les trois cas, on a pu remarquer que le champ électromagnétique présentait une symétrie axiale de révolution autour de l'axe A1.

Dans le cas d'une enceinte présentant un diamètre interne d'environ 215 mm, on pourra par exemple utiliser un tube de quartz 16 présentant un diamètre interne d'environ 85 mm. Avec un tel dispositif, des essais ont permis de déposer, sur la face interne d'une bouteille en PET d'un volume de 500 ml, un revêtement homogène d'un matériau à base de carbone avec des vitesses moyennes de dépôt de l'ordre de 300 à 400 angströms par seconde. Ainsi, le temps de traitement permettant d'obtenir une couche barrière efficace est de l'ordre de 1 à 3 secondes, ce qui permet de mettre en oeuvre ce dispositif à échelle industrielle.

De la sorte, l'invention permet d'aboutir à un dispositif industriel pour effectuer sur la paroi interne du récipient un dépôt présentant toutes les qualités requises, notamment en termes de propriétés barrières, dans un temps très court. De plus, ce dispositif est suffisamment simple et compact pour pouvoir être installé sur une machine tournante capable de traiter un nombre important de récipients par heure.

Par ailleurs, un tel dispositif peut être utilisé pour effectuer d'autres types de traitements que les dépôts de revêtements, par exemple des traitements mettant en jeu un gaz ou un mélange de gaz tel que l'oxygène, l'azote ou l'argon qui ne provoquent pas de dépôt de matière mais qui, portés à l'état de plasma, modifient en surface la structure du matériau constitutif du récipient. Il peut aussi être utilisé pour traiter la surface externe du récipient. Dans ce cas, il faudra bien entendu que le fluide réactif soit injecté dans la cavité mais à l'extérieur du récipient.

## Revendications

1. Dispositif pour le traitement de surface d'un récipient, du type dans lequel le traitement est réalisé à l'aide d'un plasma à basse pression par excitation d'un fluide réactif grâce à des ondes électromagnétiques de type micro-ondes, et du type dans lequel le récipient est placé dans une enceinte (12) en matériau conducteur à l'intérieur de laquelle les micro-ondes sont introduites par l'intermédiaire d'un dispositif de couplage,
**caractérisé en ce que** l'enceinte (12) est cylindrique de révolution autour d'un axe principal (A1) du récipient (24), **en ce que** le dispositif de couplage comporte un tunnel guide d'onde (15) qui s'étend selon une direction sensiblement perpendiculaire à l'axe (A1) de l'enceinte et qui débouche dans une paroi latérale de celle-ci sous la forme d'une fenêtre qui, en projection sur un plan tangent à l'enceinte, présente une forme rectangulaire dont la plus petite dimension correspond à sa dimension selon la direction de l'axe de l'enceinte, et **en ce que** le diamètre interne de l'enceinte (12) est tel que les micro-ondes se propagent dans l'enceinte principalement selon un mode dans lequel le champ électrique résultant de la propagation des micro-ondes présente une symétrie axiale de révolution.

2. Dispositif selon la revendication 1, **caractérisé en ce que**, lors de son utilisation pour le traitement de surface d'un récipient et lorsque les micro-ondes sont introduites dans l'enceinte (12) en l'absence de récipient (24), la variation de l'intensité du champ électrique présente deux maxima sur un rayon de l'enceinte.

3. Dispositif selon la revendication 2, **caractérisé en ce que** les micro-ondes ont une fréquence de 2,45 GHz, et **en ce que** le diamètre interne de l'enceinte (12) est compris entre 213 et 217 mm.

4. Dispositif selon la revendication 1, **caractérisé en ce que**, lors de son utilisation pour le traitement de surface d'un récipient et lorsque les micro-ondes sont introduites dans l'enceinte en l'absence de récipient, la variation de l'intensité du champ électrique présente trois maxima sur un rayon de l'enceinte.

5. Dispositif selon la revendication 4, **caractérisé en ce que** les micro-ondes ont une fréquence de 2,45 GHz, et **en ce que** le diamètre interne de l'enceinte (12) est compris entre 334 et 340 mm.

6. Dispositif selon la revendication 1, **caractérisé en ce que**, lors de son utilisation pour le traitement de surface d'un récipient et lorsque les micro-ondes sont introduites dans l'enceinte en l'absence de récipient, la variation de l'intensité du champ électrique présente quatre maxima sur un rayon de l'enceinte.

7. Dispositif selon la revendication 6, **caractérisé en ce que** les micro-ondes ont une fréquence de 2,45 GHz, et **en ce que** le diamètre interne de l'enceinte est compris entre 455 et 465 mm.

8. Dispositif selon l'une quelconque des revendications précédentes, **caractérisé en ce que** le tunnel guide d'onde (15) est de section rectangulaire.

9. Dispositif selon la revendication 8, **caractérisé en ce que**, lors de son utilisation pour le traitement de surface d'un récipient, les micro-ondes ont une fréquence de 2,45 GHz, **en ce que** la section du tunnel guide d'onde (15) présente des dimensions d'environ 43 mm selon la direction de l'axe (A1) de l'enceinte (12) et d'environ 86 mm selon la direction perpendiculaire.

10. Dispositif selon l'une quelconque des revendications précédentes, **caractérisé en ce que**, lors de son utilisation pour le traitement de surface d'un récipient, le fluide réactif est introduit à l'intérieur du récipient (24) de manière que le traitement s'effectue sur la face interne du récipient.

11. Dispositif selon l'une quelconque des revendications précédentes, **caractérisé en ce que**, lors de son utilisation pour le traitement de surface d'un récipient, le fluide réactif est introduit dans l'enceinte (12), à l'extérieur du récipient (24), de manière que le traitement s'effectue sur la face externe du récipient.

12. Dispositif selon l'une quelconque des revendications précédentes, **caractérisé en ce que**, lors de son utilisation pour le traitement de surface d'un récipient, à l'intérieur de l'enceinte (12), une cavité (18) est délimitée par une paroi (16) réalisée en un matériau qui est sensiblement transparent aux micro-ondes, et **en ce que** le récipient (24) est reçu à l'intérieure de la cavité (18).

13. Dispositif selon l'une quelconque des revendications précédentes, **caractérisé en ce que**, lors de son utilisation pour le traitement de surface d'un récipient, le traitement comprend une étape de dépôt d'un matériau par plasma basse pression.

## Patentansprüche

1. Vorrichtung zur Oberflächenbehandlung eines Behälters jener Art, bei der die Behandlung mittels eines Niederdruckplasmas durch Erregung eines reaktiven Fluids aufgrund von elektromagnetischen Wellen der Mikrowellenart erfolgt, und jener Art, bei der der Behälter in einen Raum (12) aus leitendem Material angeordnet ist, in den die Mikrowellen mittels einer Kopplungsvorrichtung eingeleitet werden,
**dadurch gekennzeichnet, dass** der Raum (12) zur einer Hauptachse (A1) des Behälters (24) zylindrisch und rotationssymmetrisch ist und dass die Kopplungsvorrichtung einen Wellenführungstunnel (15) aufweist, der sich in einer im Wesentlichen senkrecht zur Achse (A1) des Raums verlaufenden Richtung erstreckt und in Form eines Fensters in einer Seitenwand davon mündet, wobei das Fenster in Projektion auf eine tangential zum Raum verlaufende Ebene eine rechteckige Form aufweist, deren kleinste Abmessung ihrer Abmessung in Richtung der Achse des Raums entspricht, und dass der Innendurchmesser des Raums (12) derart ist, dass die Mikrowellen sich hauptsächlich gemäß einem Modus im Raum ausbreiten, in dem das sich aus der Ausbreitung der Mikrowellen ergebende elektrische Feld eine axiale Rotationssymmetrie aufweist.

2. Vorrichtung nach Anspruch 1, **dadurch gekennzeichnet, dass** bei ihrer Verwendung zur Oberflächenbehandlung eines Behälters und bei der Einleitung der Mikrowellen in den Raum (12) bei Fehlen des Behälters (24) die Änderung der Stärke des elektrischen Felds zwei Maxima auf einem Radius des Raums aufweist.

3. Vorrichtung nach Anspruch 2, **dadurch gekennzeichnet, dass** die Mikrowellen eine Frequenz von 2,45 GHz aufweisen und dass der Innendurchmesser des Raums (12) zwischen 213 und 217 mm liegt.

4. Vorrichtung nach Anspruch 1, **dadurch gekennzeichnet, dass** bei ihrer Verwendung zur Oberflächenbehandlung eines Behälters und bei Einleitung der Mikrowellen in den Raum bei Fehlen des Behälters die Änderung der Stärke des elektrischen Felds drei Maxima auf einem Radius des Raums aufweist.

5. Vorrichtung nach Anspruch 4, **dadurch gekennzeichnet, dass** die Mikrowellen eine Frequenz von 2,45 GHz aufweisen und dass der Innendurchmesser des Raums (12) zwischen 334 und 340 mm liegt.

6. Vorrichtung nach Anspruch 1, **dadurch gekennzeichnet, dass** bei ihrer Verwendung zur Oberflächenbehandlung eines Behälters und bei Einleitung der Mikrowellen in den Raum bei Fehlen des Behälters die Änderung der Stärke des elektrischen Felds vier Maxima auf einem Radius des Raums aufweist.

7. Vorrichtung nach Anspruch 6, **dadurch gekennzeichnet, dass** die Mikrowellen eine Frequenz von 2,45 GHz aufweisen und dass der Innendurchmesser des Raums zwischen 455 und 465 mm liegt.

8. Vorrichtung nach einem der vorhergehenden Ansprüche, **dadurch gekennzeichnet, dass** der Wellenführungstunnel (15) einen rechteckigen Querschnitt aufweist.

9. Vorrichtung nach Anspruch 8, **dadurch gekennzeichnet, dass** bei ihrer Verwendung zur Oberflächenbehandlung eines Behälters die Mikrowellen eine Frequenz von 2,45 GHz aufweisen und dass der Querschnitt des Wellenführungstunnels (15) Abmessungen von ca. 43 mm in Richtung der Achse (A1) des Raums (12) und von ca. 86 mm in senkrechter Richtung aufweist.

10. Vorrichtung nach einem der vorhergehenden Ansprüche, **dadurch gekennzeichnet, dass** bei ihrer Verwendung zur Oberflächenbehandlung eines Behälters das reaktive Fluid in das Innere des Behälters (24) eingeleitet wird, so dass die Behandlung an der Innenfläche des Behälters erfolgt.

11. Vorrichtung nach einem der vorhergehenden Ansprüche, **dadurch gekennzeichnet, dass** bei ihrer Verwendung zur Oberflächenbehandlung eines Behälters das reaktive Fluid auf der Außenseite des Behälters (24) in den Raum (12) eingeleitet wird, so dass die Behandlung an der Außenfläche des Behälters erfolgt.

12. Vorrichtung nach einem der vorhergehenden Ansprüche, **dadurch gekennzeichnet, dass** bei ihrer Verwendung zur Oberflächenbehandlung eines Behälters im Inneren des Raums (12) ein Hohlraum (18) durch eine Wand (16) begrenzt wird, die aus einem für Mikrowellen im Wesentlichen durchlässigen Material besteht und dass der Behälter (24) im Inneren des Hohlraums (18) aufgenommen wird.

13. Vorrichtung nach einem der vorhergehenden Ansprüche, **dadurch gekennzeichnet, dass** bei ihrer Verwendung zur Oberflächenbehandlung eines Behälters die Behandlung einen Schritt des Abscheidens eines Materials durch Niederdruckplasma umfasst.

## Claims

1. Device for the surface treatment of container, of the type in which the treatment is carried out using a low-pressure plasma by excitation of a reactive fluid by means of microwave-type electromagnetic waves and of the type in which the container is placed in a chamber (12) made of conducting material into which the microwaves are introduced via a coupling device,
**characterized in that** the chamber (12) is axisymmetric about a principal axis (A1) of the container (24), **in that** the coupling device comprises a waveguide tunnel (15) which extends along a direction substantially perpendicular to the axis (A1) of the chamber and which emerges in a side wall of the latter in the form of a window which, in projection on a plane tangential to the chamber, has a rectangular shape, the smaller dimension of which corresponds to its length along the direction of the axis of the chamber, and **in that** the internal diameter of the chamber (12) is such that the microwaves propagate in the chamber principally in a mode in which the electric field resulting from the propagation of the microwaves has axial symmetry of revolution.

2. Device according to Claim 1, **characterized in that**, when it is used for the surface treatment of a container and when the microwaves are introduced into the chamber (12) in the absence of the container (24), the variation in the intensity of the electric field has two maxima along a radius of the chamber.

3. Device according to Claim 2, **characterized in that** the microwaves have a frequency of 2.45 GHz and **in that** the internal diameter of the chamber (12) is between 213 and 217 mm.

4. Device according to Claim 1, **characterized in that**, when it is used for the surface treatment of a container and when the microwaves are introduced into the chamber in the absence of the container, the variation in the intensity of the electric field has three maxima along a radius of the chamber.

5. Device according to Claim 4, **characterized in that** the microwaves have a frequency of 2.45 GHz and **in that** the internal diameter of the chamber (12) is between 334 and 340 mm.

6. Device according to Claim 1, **characterized in that**, when it is used for the surface treatment of a container and when the microwaves are introduced into the chamber in the absence of the container, the variation in the intensity of the electric field has four maxima along a radius of the chamber.

7. Device according to Claim 6, **characterized in that** the microwaves have a frequency of 2.45 GHz and **in that** the internal diameter of the chamber is between 455 and 465 mm.

8. Device according to any one of the preceding claims, **characterized in that** the waveguide tunnel (15) is of rectangular cross section.

9. Device according to Claim 8, **characterized in that**, when it is used for the surface treatment of a container, the microwaves have a frequency of 2.45 GHz and **in that** the cross section of the waveguide tunnel (15) has a length of about 43 mm along the direction of the axis (A1) of the chamber (12) and a length of about 86 mm along the perpendicular direction.

10. Device according to any one of the preceding claims, **characterized in that**, when it is used for the surface treatment of a container, the reactive fluid is introduced into the container (24) so that the treatment is carried out on the internal face of the container.

11. Device according to any one of the preceding claims, **characterized in that**, when it is used for the surface treatment of a container, the reactive fluid is introduced into the chamber (12), outside the container (24), so that the treatment is carried out on the external face of the container.

12. Device according to any one of the preceding claims, **characterized in that**, when it is used for the surface treatment of a container, inside the chamber (12), a cavity (18) is bounded by a wall (16) made of a material which is substantially transparent to the microwaves and **in that** the container (24) is housed inside the cavity (18).

13. Device according to any one of the preceding claims, **characterized in that**, when it is used for the surface treatment of a container, the treatment comprises a step of depositing a material by low-pressure plasma.
